Europäisches Patentamt

European Patent Office

Office européen des brevets

(11) Veröffentlichungsnummer: **0 123 981**
A2

# (12) EUROPÄISCHE PATENTANMELDUNG

(21) Anmeldenummer: **84104098.3**

(51) Int. Cl.³: **G 02 F 1/137**

(22) Anmeldetag: **12.04.84**

(30) Priorität: **29.04.83 CH 2319/83**

(43) Veröffentlichungstag der Anmeldung: **07.11.84**
**Patentblatt 84/45**

(84) Benannte Vertragsstaaten: **AT BE CH DE FR GB IT LI NL SE**

(71) Anmelder: **F. HOFFMANN-LA ROCHE & CO.**
**Aktiengesellschaft, CH-4002 Basel (CH)**

(72) Erfinder: **Gerber, Paul, Dr., Margerethenweg 14,**
**CH-4310 Rheinfelden (CH)**

(74) Vertreter: **Körber, Wolfhart, Dr. et al, Patentanwälte**
**Dipl.-Ing. H. Mitscherlich Dipl.-Ing. K. Gunschmann**
**Dr.rer.nat. W. Körber Dipl.Ing. J. Schmidt-Evers Dipl.-Ing.**
**W. Melzer Steinsdorfstrasse 10, D-8000 München 22 (DE)**

(54) **Flüssigkristallzelle.**

(57) Zwischen zwei Trägerplatten mit Ansteuerelektrode ist ein cholesterischer Flüssigkristall angeordnet, der in zwei optisch verschiedenen, stabilen Texturen existiert und eine dielektrische Anisotropie besitzt, die bei niedrigen Frequenzen positiv, bei höheren Frequenzen negativ ist, wodurch der Flüssigkristall durch Anlegen einer niederfrequenten Spannung eine der beiden stabilen Texturen und durch Anlegen einer höherfrequenten Spannung die andere stabile Textur annimmt. Die beiden optisch verschiedenen Texturen sind ohne anliegende Spannung langzeitstabil. Dadurch sind energiesparende Anzeigen möglich.

## Flüssigkristallzelle

Die Erfindung betrifft eine Flüssigkristallzelle zur optischen Darstellung elektrischer Signale mit einem cholesterischen Flüssigkristall zwischen zwei mit Ansteuerelektroden versehenen Trägerplatten.

Flüssigkristallzellen mit cholesterischen Flüssigkristallen sind bekannt. Bei diesen Zellen wird der Umstand benutzt, dass cholesterische Flüssigkristalle in mehreren, d.h. in der Regel in zwei optisch unterschiedlichen Zustandsformen existieren, zwischen denen sie durch Anlegen geeigneter Spannungen hin- und hergeschaltet werden können.

In einer Zelle, ohne anliegende elektrische Spannung ist im allgemeinen eine Zustandsform stabil, bei welcher die Moleküle im wesentlichen parallel zu den Trägerplatten liegen, und somit die cholesterische Helixachse im wesentlichen normal auf der Substratebene steht. Zustandsformen, die eine derartige Molekülanordnung aufweisen, werden in der Literatur meistens als Grandjean- oder planare Texturen bezeichnet. Da diese Begriffe aber einerseits für eine theoretische Idealform der entsprechenden Textur stehen, andererseits aber in der Praxis häufig auch noch zur Bezeichnung mehr oder weniger deformierter Texturen herangezogen werden

Bu/ 23.2.84

und damit zu Missverständnissen Anlass geben können, werden sie für den Zweck der vorliegenden Beschreibung vermieden. Statt dessen wird jeweils die Richtung der Helixachse für die Beschreibung einer Textur benutzt.

Bei der zweiten hier interessierenden Struktur liegt die Helixachse im wesentlichen parallel zu den Trägerplatten. Diese Textur liegt wegen der ungünstigen Anpassungsverhältnisse in den Randzonen energetisch höher als diejenige mit plattennormaler Helixachse. Deshalb bildet sich bei kleinem Verhältnis von Zellendicke d zu cholesterischer Schraubungshöhe P dieser Zustand ohne angelegtes Feld allmählich wieder in die stabilere Textur mit plattennormaler Helixachse zurück. Bei grossen Werten von $\frac{d}{P}$ (typisch grösser als zehn) ist der Einfluss der Randzone jedoch so gering, dass sich die Textur mit plattenparalleler Helixachse auch über Tage hinweg nicht zurückbildet. In diesen Fällen scheint sogar die Frage nach der grösseren Stabilität einer der beiden Texturen noch offen zu sein.

Die optischen Eigenschaften der beiden Zustände sind sehr unterschiedlich. Die Textur mit plattennormaler Helixachse reflektiert entweder links- oder rechtsdrehendes zirkular polarisiertes Licht der Wellenlängen $\lambda$ um den Wert $\bar{n} \cdot P$, wobei $\bar{n}$ mittlere Brechungsindex ist. Für einen höheren Reflexionskoeffizienten muss dabei gelten, dass $d \cdot \Delta n$ grösser als die Wellenlänge ist, wobei $\Delta n$ die Anisotropie des Brechungsindex ist. Die zweite, nicht reflektierte zirkular polarisierte Komponente des einfallenden Lichts durchquert die Textur im wesentlichen ungestört. Vor absorbierendem Hintergrund erscheinen für $\bar{n} \cdot P$ im sichtbaren Wellenlängenbereich die typischen cholesterischen Reflexionsfarben.

Der Flüssigkristall im Zustand mit plattenparalleler Helixachse dagegen lässt Licht unreflektiert passieren, wobei jedoch eine Vorwärtsstreuung in einem engen Winkelbereich eintritt. Vor absorbierendem Hintergrund erscheint die Flüssigkristallschicht in diesem Zustand deshalb dunkel.

Diese beiden Zustände zeigen vor gut absorbierendem Hintergrund und bei gut entspiegelten Oberflächen einen eindrücklichen Kontrast. Auch in Transmission lässt sich ein guter Kontrast erreichen, wenn wenig dispergierendes Licht so durch Blenden geführt wird, dass das im Zustand mit plattenparalleler Helixachse gestreute Licht die Blenden nicht mehr passieren kann. In dieser Betriebsweise wird die Reflexionseigenschaft des Zustandes mit plattennormaler Helixachse nicht benötigt.

Die beiden vorstehend definierten Texturen und ihre optischen Eigenschaften wurden schon anfangs unseres Jahrhunderts beschrieben. Einer Verwendung der durch sie bestimmten optischen Unterschiede stand jedoch der Nachteil entgegen, dass es nicht gelang, die beiden Zustände auf einfache Weise in beiden Richtungen ineinander überzuführen, etwa durch elektrische Felder.

Aus der US-Patentschrift Nr. 3,642,348 ist es bekannt, dass ein cholesterischer Flüssigkristall, der sich im Ruhestand in der Grandjean-Textur befindet, durch Anlegen eines Gleichspannungs- oder eines niederfrequenten Wechselspannungsfeldes in die fokalkonische Textur umgewandelt werden kann. Nach Reduzierung oder Abschalten des Feldes relaxiert der Kristall wieder in seinen Ruhestand, die Grandjean-Textur. Diese Rückbildung kann innerhalb von Sekundenbruchteilen erfolgen, kann sich aber auch über Stunden erstrecken. Sie kann durch mechanische Massnahmen oder durch Erhitzen beschleunigt werden.

Aus der deutschen Offenlegungsschrift 25 38 212 ist bekannt, dass die Texturumwandlung vom Grandjean- in den fokalkonischen Zustand unter Mitwirkung eines elektrohydrodynamischen Effekts erfolgt, der sich in dielektrisch negativem nematischem Material bei genügend niedrigen Frequenzen einstellt.

Aus der US-Patentschrift Nr. 3,680,950 ist es bekannt, einen Flüssigkristall mit negativer Dielektrizitäts-Anisotropie durch den orientierenden Effekt eines höherfrequenten elektrischen Wechselfeldes aus dem fokalkonischen in den Grandjean-Zustand umzuschalten.

Damit weisen alle diese Effekte, wenn man sie zu einer in beiden Richtungen schaltbaren Anzeigezelle kombiniert, einen erheblichen Nachteil auf: Infolge des Stromflusses, der die elektrohydrodynamischen Turbulenzen hervorruft, wird der Flüssigkristall langsam, aber kontinuierlich zersetzt. Seine Lebensdauer ist gering.

Es ist zu beachten, dass es sich bei dem hier interessierenden Effekt und den vorstehend erwähnten bekannten Effekten um den Texturwechsel innerhalb der cholesterischen Phase und nicht um davon grundsätzlich verschiedene Phasenwechseleffekte handelt.

Bei Phasenwechseleffekten weist der Flüssigkristall nur in einem der beiden Schaltzustände eine cholesterische Struktur auf, während er bei angelegtem Haltefeld homöotropnematisch ist.

In der Deutschen Auslegeschrift Nr. 25,42,189 ist beispielsweise eine solche Zelle beschrieben, die ein cholesterisches Flüssigkristallgemisch enthält, das eine energetisch stabile fokalkonische Struktur aufweist, wenn kein elektrisches Feld anliegt, und aus diesem Zustand in eine homöotropnematische Struktur umgeschaltet werden kann, in der es bei Anliegen eines geeigneten Haltefeldes bleibt. Nach Abschalten des Haltefeldes geht der Flüssigkristall wieder in den stabilen fokalkonischen Zustand über.

Abgesehen davon, dass    dieser Phasenwechseleffekt vom hier betrachteten Texturwechsel grundsätzlich verschieden ist, weist auch der Phasenwechsel so erhebliche Nachteile auf, dass er bisher keine technische Anwendung gefunden hat, obwohl er seit langem bekannt ist. Ausserdem sind für den Phasenwechsel eine sehr hohe Ansteuerspannung und für die Aufrechterhaltung des nicht-stabilen Zustands eine hohe Haltespannung erforderlich.

Der Erfindung liegt die Aufgabe zugrunde, eine Flüssigkristallzelle bereitzustellen, die durch die orientierende
Wirkung elektrischer Felder zwischen zwei stabilen, optisch
verschiedenen Zuständen geschaltet werden kann und bei der
kein Ionenstrom im Flüssigkristall fliessen muss, so dass gut isolierende Flüssigkristall-Materialien gebraucht werden können,
um Degradationserscheinungen zu vermeiden.

Erfindungsgemäss wird dies dadurch erreicht, dass bei
einer Zelle der eingangs genannten Art der Flüssigkristall
in zwei optisch verschiedenen stabilen Texturen existiert
und eine dielektrische Anisotropie besitzt, die bei Frequenzen unterhalb eines Schwellwerts positiv ist, wodurch
der Flüssigkristall durch Anlegen einer Wechselspannung mit
einer solchen niedrigen Frequenz eine der beiden stabilen
Texturen annimmt, bei Frequenzen oberhalb des Schwellwerts
negativ ist, wodurch der Flüssigkristall durch Anlegen einer
Wechselspannung mit einer solchen höheren Frequenz in den
anderen stabilen Zustand übergeht.

Der cholesterische Flüssigkristall ist vorzugsweise
ein Gemisch aus nematischen Flüssigkristallen mit cholesterischen Zusätzen.

Die beiden stabilen Zustandformen, in denen sich der
Flüssigkristall befindet, sind die Textur mit plattenparalleler Helixachse, die der Flüssigkristall beim Anlegen einer
Niederfrequenzspannung annimmt, und die Textur mit plattensenkrechter Helixachse, in die der Flüssigkristall bei Anlegen einer höherfrequenten Spannung übergeht.

Die dem Flüssigkristall zugewandte Oberfläche der
oberen Platte, d.h. der Platte, durch die der Lichteinfall
erfolgt, weist vorzugsweise eine homogene Wandorientierung
auf. Die gewünschten elektro-optischen Effekte treten jedoch
auch in Zellen ein die keine, bzw. homöotrope oder auch hydride
Wandorientierungen aufweisen.

Nachfolgend werden anhand der beiliegenden Zeichnungen Ausführungsformen der Erfindung beschrieben. Es zeigen

Fig. 1     eine schematische Darstellung einer Zelle mit einem cholesterischen Flüssigkristall mit plattenparalleler Helixachse

Fig. 2     eine schematische Darstellung einer Zelle mit einem Flüssigkristall mit plattennormaler Helixachse

Fig. 3     eine schematische Kurve des Verlaufs der dielektrischen Anisotropie in Abhängigkeit von der Frequenz eines am Flüssigkristall anliegenden elektrischen Feldes.

Fig. 4     eine schematische Darstellung einer mit dem neuen Effekt zu verwirklichenden Matrixanzeige

Fig. 5     eine schematische Darstellung der Signalformen zur Ansteuerung einer Matrixanzeige gemäss Fig. 4.

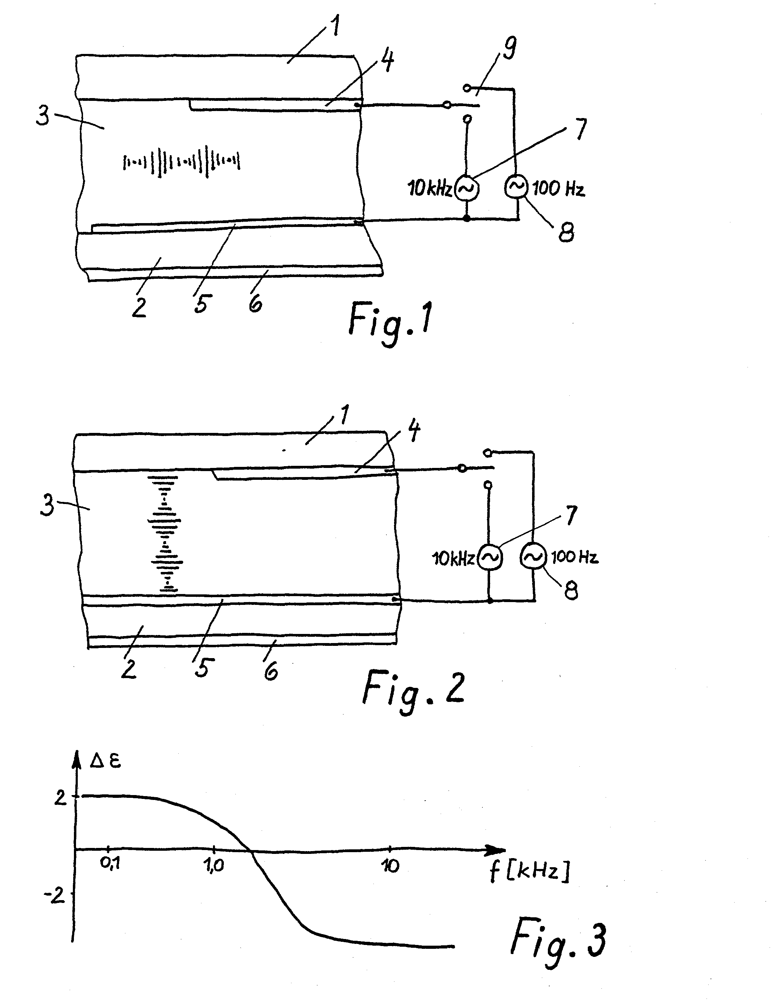

Fig. 1 zeigt einem schematischen Querschnitt durch einen Teil einer Flüssigkristallzelle. Die Zelle besteht wie üblich aus zwei im Abstand voneinander angeordneten Trägerplatten 1, 2, zwischen denen eine cholesterische Flüssigkristallschicht 3 angeordnet ist.

Die obere Trägerplatte 1 sei diejenige, durch die der Lichteinfall erfolgt und auf deren Seite sich im Falle einer reflektiv betriebenen Anzeige der Beobachter befindet. Die dem Flüssigkristall zugewandte Oberfläche der Trägerplatte 1 ist so behandelt, dass sie die angrenzenden Flüssigkristallmoleküle homogen orientiert. Diese sogenannte homogene Wandorientierung kann mit den üblichen Methoden erzeugt werden, d.h. also beispielsweise durch Reiben, Schrägbedampfen etc..

Die homogene Wandorientierung der Trägerplatte 1 ist nicht unbedingt für die Funktion der Anzeigezelle erforderlich. Sie dient aber zur Erzielung einer besseren optischen Homogenität, insbesondere im Zustand in dem die Helixachse des Flüssigkristalls senkrecht zu den Trägerplatten steht.

Beide Trägerplatten 1, 2 sind auf den dem Flüssigkristall zugewandten Seiten mit Elektroden versehen, über die die Ansteuerung erfolgt. Diese Elektroden bestehen in bekannter Weise aus dünnen, meistens aufgedampften Schichten von Indiumoxid etc..

Da die Anzeige auf dem optischen Unterschied zwischen den beiden Texturen des cholesterischen Flüssigkristalls beruht, muss der Flüssigkristall durch die obere Trägerplatte 1 hindurch sichtbar sein. Das heisst die Trägerplatte 1 muss aus Glas, durchsichtigem Kunststoff etc. bestehen. Auch die obere Elektrode 4 muss durchsichtig sein.

Die untere Trägerplatte soll Licht absorbieren, was üblicherweise dadurch erreicht wird, dass auch die Trägerplatte lichtdurchlässig ist und auf ihrer äusseren Seite eine absorbierende Schicht 6 angebracht ist. Selbstverständlich sind auch andere Konfigurationen denkbar, beispielsweise absorbierende Ausbildung der Elektrode 5 oder der Trägerplatte 2 selbst.

Die Elektroden 4, 5 sind mit einer Ansteuerelektronik verbunden, die für den Zweck dieser Beschreibung lediglich schematisch durch zwei Wechselspannungsquellen 7, 8 mit verschiedenen Frequenzen und einem Schalter 9 dargestellt ist. Für die konkrete und detaillierte Ausbildung der Ansteuerelektronik wird auf die umfangreiche einschlägige Literatur verwiesen, die dem Fachmann bekannt ist.

Die Flüssigkristallschicht 3 besteht aus einer sogenannten Zweifrequenzmischung, wie sie etwa in Appl. Phys. Lett. 41, 697(1982) beschrieben wurde, welcher geeignete chirale Moleküle zugemischt werden, sodass einerseits die Zweifrequenzeigenschaft erhalten bleibt, andererseits in der Mischung die gefragten cholesterischen Eigenschaften induziert werden, im vorliegenden Fall also das Reflexionsvermögen im sichtbaren Bereich.

Eine besonders gut geeignete Flüssigkristallmischung setzt sich zum Beispiel wie folgt zusammen: Die nematische Zweifrequenzmischung besteht aus folgenden Komponenten in den angegebenen Gewichtsanteilen:

| Komponente | Gew. % |
|---|---|
| $C_4H_9$—⬡—COO—⟨O⟩—$OC_2H_5$ | 9,26 % |
| $C_4H_9$—⬡—COO—⟨O⟩—$OC_5H_{11}$ | 13,05 % |
| $C_5H_{11}$—⬡—COO—⟨O⟩—$OCH_3$ | 8,38 % = 2539 |
| $C_5H_{11}$—⬡—COO—⟨O⟩—$OC_3H_7$ | 10,11 % |
| $C_5H_{11}$—⬡—$CH_2CH_2$—⟨O⟩—$OC_2H_5$ | 5,69 % |
| $C_2H_5$—⬡—⟨O⟩(N–N)—$C_3H_7$ | 2,92 % |
| $C_5H_{11}$—⬡—⟨O⟩(N–N)—$C_3H_7$ | 7,11 % = 2545 |
| $C_5H_{11}$—⬡—⟨O⟩(N–N)—$C_3H_7$ | 9,10 % |
| $C_7H_{15}$—⬡—⟨O⟩(N–N)—$C_3H_7$ | 4,55 % |
| $C_7H_{15}$—⟨O⟩—⟨O⟩—COO—⟨O⟩(Cl)—COO—⟨O⟩—C(CH_3)=C(CN)(CN) | 6,14 % |
| $C_7H_{15}$—⬡—$CH_2CH_2$—⟨O⟩—COO—⟨O⟩(Cl)—COO—⟨O⟩—C(CH_3)=C(CN)(CN) | 4,39 % |
| $C_7H_{15}$—⟨O⟩—⟨O⟩—COO—⟨O⟩(Cl)—COO—⟨O⟩—CN | 3,51 % |
| $C_7H_{15}$—⬡—$CH_2CH_2$—⟨O⟩—COO—⟨O⟩(Cl)—COO—⟨O⟩—CN | 3,51 % |
| $C_5H_{11}$—⬡—⟨O⟩—$C_3H_7$ | 8,77 % |
| $C_5H_{11}$—⬡—⟨O⟩—⟨O⟩—$CH_2CH_2$—⬡—$C_4H_9$ | 3,51 % |
| | 100,00 % |

Diese zwischen $-6^{\circ}$C und $+ 79^{\circ}$C nematische Mischung besitzt bei $22^{\circ}$C eine Uebergangsfrequenz fc von ca. 1,4 kHz. Bei Frequenzen $<$ fc ist die dielektrische Anisotropie positiv, für $f >$ fc negativ.

Zu dieser nematischen Mischung werden folgende chirale Zusätze (in Gew. %) zugefügt, um eine gut sichtbare Farbwirkung im grünen Spektralbereich zu erzielen.

Gew. %

2,0 wt %

1,7 wt %

2,8 wt %

2,1 wt %

1,9 wt %

Mit der in Figur 1 dargestellten Textur besitzt der Flüssigkristall die für die cholesterische Phase typische schraubenförmig verdrillte Molekülanordnung, wobei die Schraubenachse mehr oder weniger parallel zu den Plattenoberflächen liegt. Dies ist in Fig. 1 durch eine Reihe von auf die Zeichenebene projizierten Molekülen schematisch angedeutet.

Wird der Schalter 9 kurzzeitig mit der Spannungsquelle 7 verbunden, so gelangt ein Impuls mit einer Frequenz von mehr als 1,4 kHz, vorzugsweise etwa 10 kHz, an den Flüssigkristall 3, worauf dieser in den Zustand mit plattennormaler Helixachse übergeht. Dieser Zustand ist in Fig. 2 gezeigt. Bei der in Fig. 2 gezeigten schematischen Darstellung handelt es sich um dieselbe Zelle wie in Fig. 1. Lediglich der Flüssigkristall 3 weist jetzt eine andere Textur auf, die sich dadurch auszeichnet, dass die ausgebildeten Schraubenwindungen mit ihrer Achse senkrecht auf den Trägerplatten 1, 2 stehen. Die Moleküle sind in diesem Zustand somit im wesentlichen parallel zu den Plattenoberflächen orientiert.

Die Textur mit plattennormaler Helixachse bleibt ebenfalls ohne Energiezufuhr von aussen über lange Zeit hinweg unverändert bestehen. Dies ist dadurch angedeutet, dass auch in Fig. 2 der Schalter 9 geöffnet ist. Wird der Schalter 9 so umgelegt, dass die Spannungsquelle 8 mit den Elektroden verbunden ist, d.h. wird ein Spannungsimpuls mit einer Frequenz von weniger als 1,4 kHz, d.h. vorzugsweise etwa 100 Hz zugeführt, so geht der Flüssigkristall wieder in seine Textur mit plattenparalleler Helixachse über.

Die Anzeigezelle besitzt also zwei wirklich stabile Zustände und kann durch Anlegen von Wechselspannungsimpulsen mit unterschiedlichen Frequenzen jeweils von einem zum anderen Zustand geschaltet werden. Zur Beibehaltung der beiden Zustände braucht es keine Haltespannung. Wie die Experimente ergeben haben sind beide Zustände ohne angelegte Spannung über mehrere Wochen unverändert stabil.

In Versuchszellen wurden die Umschaltvorgänge mittels Rechtecksignalen von 60 Volt RMS durchgeführt. Zu einer 10 µm dicken Zelle mit cholesterischer Füllung mit einer Ganghöhe P von P=0.38 µm führte das zu Schaltzeiten von ca. 250 ms für das Schalten in den Zustand mit plattennormaler Helixachse und von ca. 50 ms für den Rückschaltprozess. Bei kleineren Spannungen waren die Schaltzeiten länger, und die Texturänderungen fanden unterhalb gewisser Schwellenwerte kaum mehr statt. Bei Anlegen der Niederfrequenz findet bei ca. doppelter Spannung, d.h. bei 120 V der cholesterischnematische Phasenübergang statt. Allerdings befindet man sich dann schon im Bereich hoher Durchschlagsgefahr.

Durch Variieren der Spannungen und Modifizieren der Zweifrequenzmischungen dürften noch Verbesserungen der Schaltzeiten erzielbar sein.

Der für eine Anzeige erforderliche optische Kontrast besteht darin, dass in der Textur mit plattenparalleler Helixachse der Flüssigkristall ziemlich gut lichtdurchlässig ist und damit die rückseitige Platte sichtbar ist, die gemäss ihrer absorbierender Eigenschaft dunkel erscheint. Im Zustand mit plattennormaler Helixachse findet dann die erwähnte frequenzselektive Reflexion des Lichts statt. Dies führt dazu, dass von weissem Licht nur bestimmte Anteile zurückgestreut werden und der Flüssigkristall dadurch intensiv farbig erscheint. Die jeweilige Farbe hängt von der Ganghöhe des cholesterischen Flüssigkristalls ab. Da bei den meisten cholesterischen Flüssigkristallen die Ganghöhe temperaturabhängig ist ändert sich die Farbe leicht mit wechselnder Temperatur. Es ist jedoch dem Fachmann bekannt, wie dies durch entsprechende Mischungsverhältnisse der Komponenten kompensiert werden kann.

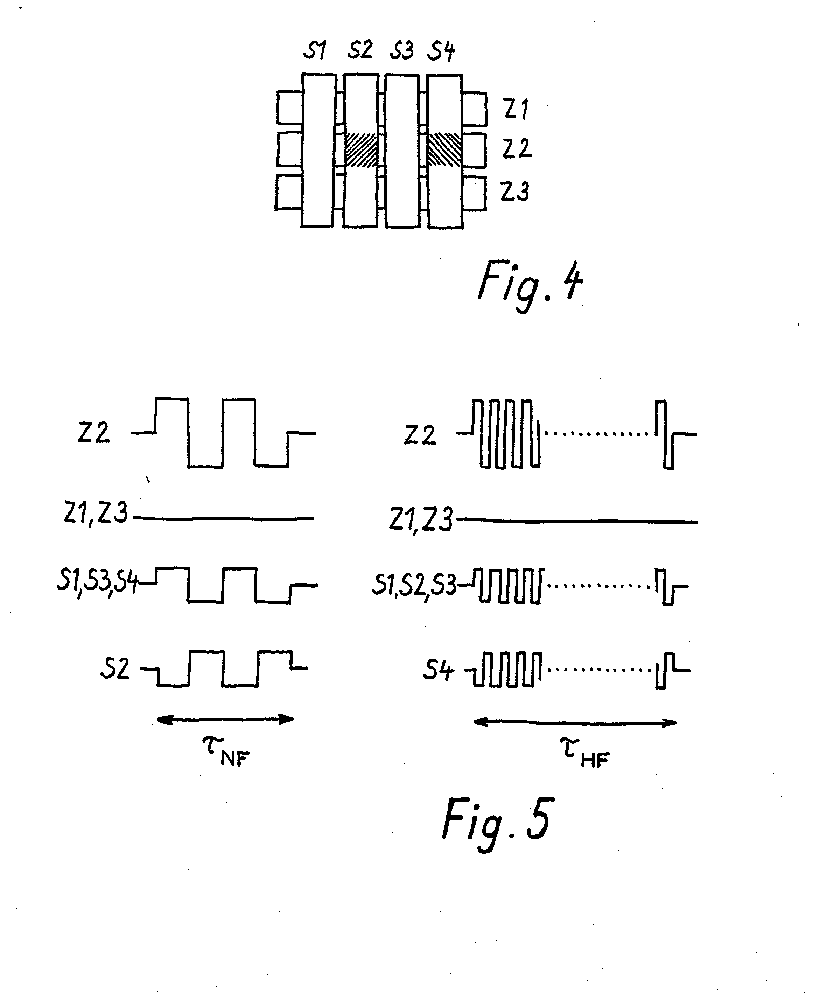

In den Figuren 4 und 5 ist die Verwendung des neuen Effekts in einer Matrixanzeige gezeigt. In dem in Fig. 4 gezeigten Ausschnitt einer Matrixanzeige soll beispielsweise die Fläche Z2/S2 in den Zustand mit plattenparalleler Helixachse, die Fläche Z2/S4 in den Zustand mit plattennormaler Helixachse gebracht werden. Alle anderen Elemente sollen ihren Zustand unverändert beibehalten.

Die darzustellende Information kann etwa zeilenweise eingelesen werden. Dabei folgen Hoch- und Niederfrequenzspannungen abwechslungsweise. An der gewählten Zeile Z2 liegt von jeder Frequenz je einmal eine Spannung von zwei Amplitudeneinheiten, während die übrigen Zeilen ohne Spannung bleiben

An den Spalten liegt stets eine Amplitudeneinheit. Für Elemente, die unverändert bleiben sollen, d.h. also in den Spalten S1 und S3 ist sie in Phase mit der Zeilenspannung. Wenn der Zustand eines Elementes neu definiert werden soll, d.h. also in den Spalten S2 und S4 ist die Spannung in Gegenphase zur entsprechenden Zeilenspannung. An den umzuschaltenden Elementen der Zeile liegen also drei Spannungseinheiten, während an allen übrigen je eine Einheit liegt.

Die Zeiten, während welchen eine Frequenz jeweils anliegt, sind dadurch bestimmt, dass unter drei Spannungseinheiten eine eindeutige Definition des Zustandes eintritt, während unter einer Einheit im Wechsel von Hoch- und Niederfrequenz beide Zustandsmöglichkeiten ungeändert bleiben. Diese Zeiten $\tau_{NF}$, $\tau_{HF}$ hängen von Material- und Zellenparametern ab und müssen von Fall zu Fall optimiert werden.

0123981

## Patentansprüche

1. Flüssigkristallzelle mit einem cholesterischen Flüssigkristall zwischen zwei mit Ansteuerelektroden versehenen Trägerplatten, dadurch gekennzeichnet, dass der Flüssigkristall in zwei optisch verschiedenen stabilen Texturen existiert und eine dielektrische Anisotropie besitzt, die bei Frequenzen unterhalb eines Schwellwerts positiv ist wodurch der Flüssigkristall durch Anlegen einer Wechselspannung mit einer solchen niedrigen Frequenz eine der beiden stabilen Texturen annimmt, bei Frequenzen oberhalb des Schwellwerts negativ ist, wodurch der Flüssigkristall durch Anlegen einer Wechselspannung mit einer höheren Frequenz die andere stabile Textur annimmt.

2. Flüssigkristallzelle nach Anspruch 1, dadurch gekennzeichnet, dass die auf der Einfallsseite des Lichts befindliche Trägerplatte auf ihrer dem Flüssigkristall zugewandten Oberfläche eine Beschaffenheit aufweist, die die Flüssigkristallmoleküle homogen orientiert.

3. Flüssigkristallzelle, nach Anspruch 1, dadurch gekennzeichnet, dass die auf der Einfallsseite des Lichts befindliche Trägerplatte auf ihrer dem Flüssigkristall zugewandten Oberfläche eine Beschaffenheit aufweist, die die Flüssigkristallmoleküle homöotrop orientiert.

4. Flüssigkristallzelle nach einem der vorangehenden Ansprüche, dadurch gekennzeichnet, dass der Flüssigkristall in einer der beiden stabilen Texturen eine parallel zu den Trägerplatten, in der anderen stabilen Textur eine senkrecht zu den Trägerplatten liegende Helixachse aufweist.

5. Flüssigkristallzelle nach einem der vorangehenden Ansprüche, dadurch gekennzeichnet, dass die Ansteuerelektroden auf einer Trägerplatte in Zeilen-, auf der anderen Trägerplatte in Spaltenleiter  unterteilt sind und auf diese

- 14 -

Weise eine Matrixanzeige bilden.

6. Flüssigkristallzelle nach Anspruch 5, dadurch gekennzeichnet, dass die Zeilen- und Spaltenleiter abwechselnd mit einem niederfrequenten und einem hochfrequenten Signal beaufschlagt werden.

7. Flüssigkristallzelle nach Anspruch 6, dadurch gekennzeichnet, dass zum Einlesen einer Zeile an dem anzusteuernden Zeilenleiter ein Signal mit einer bestimmten Amplitude und an allen anderen Zeilenleitern kein Signal anliegt, während zugleich allen Spaltenleitern ein Signal zugeführt wird, dessen Amplitude halb so gross ist wie die des Zeilensignals und für die umzuschaltenden Kreuzungspunkte gegenphasig zum Zeilensignal, für alle anderen Kreuzungspunkte mit dem Zeilensignal in Phase ist.

***

Fig.1

Fig.2

Fig.3

Fig. 4

$\tau_{NF}$

$\tau_{HF}$

Fig. 5